# EUROPEAN PATENT APPLICATION

(11) **EP 3 806 163 A1**
(43) Date of publication of application: **14.04.2021**
(21) Application number: 20200297.8
(22) Date of filing: 06.10.2020
(51) Int. Cl.: H01L 31/0224, H01L 31/068, H01L 31/18

(54) **SOLAR CELL AND MANUFACTURING METHOD THEREOF**

(30) Priority: 09.10.2019 TW 108136728
(71) Applicant: EEPV Corp., Taoyuan City 32068, Taiwan (TW)
(72) Inventor: LIN, Daniel, 32068 Taoyuan City (TW); CHANG, Kai-Yi, 32068 Taoyuan City (TW); LU, Yi-Rou, 32068 Taoyuan City (TW)
(74) Representative: D Young & Co LLP

(57) **Abstract**

A solar cell includes a substrate (110), an emitter layer (120), a first thin oxide layer (1130), a first doped silicon layer (140), a second thin oxide layer (132), and a second doped silicon layer (142). The substrate has a first side (112) and a second side (114) opposite to each other. The emitter layer is disposed on the first side of the substrate and includes a first conductivity type of dopant. The first thin oxide layer is disposed on the emitter layer. The first doped silicon layer is disposed on the first thin oxide layer and includes the first conductivity type of dopant. The second thin oxide layer is disposed on the second side of the substrate. The second doped silicon layer is disposed on the second thin oxide layer and includes a second conductivity type of dopant. A method for manufacturing the solar cell is also provided herein.

## Description

### BACKGROUND

### Field of Invention

The present disclosure relates to a solar cell and a manufacturing method for a solar cell.

### Description of Related Art

A solar cell is a device that converts solar energy into electrical energy through photovoltaic effect. In recent years, due to the rising issues of global warming and environmental awareness, coupled with the depletion of non-renewable energy sources (such as oil, coal mines), the development of the green energy industry, especially solar photovoltaic technology, has attracted more attention.

However, the current manufacturing costs of solar cells are still high; hence, improving the solar cell manufacturing process to reduce the costs and improve the yield is an important issue in this field.

### SUMMARY

Some embodiments of the present disclosure provide a solar cell including a substrate, an emitter layer, a first thin oxide layer, a first doped silicon layer, a second thin oxide layer, and a second doped silicon layer. The substrate has a first side and a second side opposite to each other. The emitter layer is disposed on the first side of the substrate and comprises a first conductivity type of dopant. The first thin oxide layer is disposed on the emitter layer. The first doped silicon layer is disposed on the first thin oxide layer and includes the first conductivity type of dopant. The second thin oxide layer is disposed on the second side of the substrate. The second doped silicon layer is disposed on the second thin oxide layer and includes a second conductivity type of dopant.

In some embodiments, in the solar cell, the thickness of the first doped silicon layer is smaller than the thickness of the second doped silicon layer.

In some embodiments, in the solar cell, the concentration of the first conductivity type of dopant in the first doped silicon layer is highest at the side adjacent to the first thin oxide layer.

In some embodiments, in the solar cell, the first doped silicon layer is configured to provide passivation function.

In some embodiments, the first doped silicon layer and the second doped silicon layer are made of polysilicon.

In some embodiments, the solar cell further includes a mask layer disposed on the second doped silicon layer.

In some embodiments, in the solar cell, the material of the mask layer includes silicon nitride, silicon oxide, or a combination thereof.

In some embodiments, the solar cell further includes a first capping layer and a second capping layer. The first capping layer is disposed on the first doped silicon layer, and the second capping layer is disposed on the second doped silicon layer.

In some embodiments, in the solar cell, each of the first capping layer and the second capping layer comprises silicon nitride, silicon oxide, or a combination thereof.

In some embodiments, the solar cell further includes: a first electrode layer and a second electrode layer. The first electrode layer is disposed on the first capping layer. The second electrode layer is disposed on the second capping layer.

In some embodiments, the solar cell is a tunnel oxide passive contact (TOPCon) solar cell.

In some embodiments, in the solar cell, the substrate is an N-type silicon substrate, the first conductivity type of dopant is a group III element, and the second conductivity type of dopant is a group V element.

In some embodiments, in the solar cell, the first conductivity type of dopant is boron, and the second conductivity type of dopant is phosphorus.

In some embodiments, in the solar cell, the substrate is a P-type substrate, the first conductivity type of dopant is a group V element, and the second conductivity type of dopant is a group III element.

In some embodiments, in the solar cell, the first conductivity type of dopant is phosphorus, and the second conductivity type of dopant is boron.

Some embodiments of the present disclosure provide a method for manufacturing a solar cell; the method comprises: providing a substrate including a first side and second side opposite to each other; performing a first doping process on the first side of the substrate to form an emitter layer doped with a first conductivity type of dopant; performing oxide deposition to form a first thin oxide layer on the emitter layer and to form a second thin oxide layer on the second side of the substrate; performing silicon deposition to form a first silicon layer on the first thin oxide layer and to form a second silicon layer on the second thin oxide layer; performing a second doping process to form the second silicon layer into a second doped layer doped with a second conductivity type of dopant; and performing a third doping process to from the first silicon layer into a first doped silicon layer doped with the first conductivity type of dopant.

In some embodiments, in the method for manufacturing the solar cell, the third doping process is a thermal diffusion process to make the first conductivity type of dopant from the emitter layer diffuse into the first silicon layer.

In some embodiments, in the method for manufacturing the solar cell, the third doping process is performed during the second doping process is performed.

In some embodiments, the method for manufacturing the solar cell further includes: depositing a mask layer on the second doped silicon layer; and performing a thinning process for the first doped silicon layer.

In some embodiments, in the method for manufacturing the solar cell, the material of the mask layer includes silicon nitride, silicon oxide, or a combination thereof.

In some embodiments, the method for manufacturing the solar cell further includes: disposing a first capping layer on the first doped silicon layer; and disposing a second capping layer on the second doped silicon layer.

In some embodiments, the method for manufacturing the solar cell further includes: disposing a first electrode layer on the first capping layer; and disposing a second electrode layer on the second capping layer. Particular and preferred aspects of the present invention are set out in the accompanying independent and dependent claims. Features of the dependent claims may be combined with features of the independent claims as appropriate, and in combinations other than those explicitly set out in the claims.

### BRIEF DESCRIPTION OF THE DRAWINGS

Aspects of the present disclosure are best understood from the following detailed description when read with the accompanying figures, which illustrate various embodiments by way of example only. It is noted that, in accordance with the standard practice in the industry, various features are not drawn to scale. In fact, the dimensions of the various features may be arbitrarily increased or reduced for clarity of discussion.
Figs. 1A and 1B are schematic cross-sectional views of a solar cell in accordance with some embodiments.
Fig. 2 is a flow chart of a method for manufacturing a solar cell in accordance with some embodiments.
Figs. 3A through 3J are schematic cross-sectional views of various intermediate structures in the manufacturing process of a solar cell in accordance with some embodiments.

### DETAILED DESCRIPTION

The following disclosure provides many different embodiments, or examples, for implementing different features of the provided subject matter. Specific examples of components and arrangements are described below to simplify the present disclosure. These are, of course, merely examples and are not intended to be limiting. For example, the formation of a first feature over or on a second feature in the description that follows may include embodiments in which the first and second features are formed in direct contact, and may also include embodiments in which additional features may be formed between the first and second features, such that the first and second features may not be in direct contact. In addition, the present disclosure may repeat reference numerals and/or letters in the various examples. This repetition is for the purpose of simplicity and clarity and does not in itself dictate a relationship between the various embodiments and/or configurations discussed.

Further, spatially relative terms, such as "beneath," "below," "lower," "above," "upper" and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures.

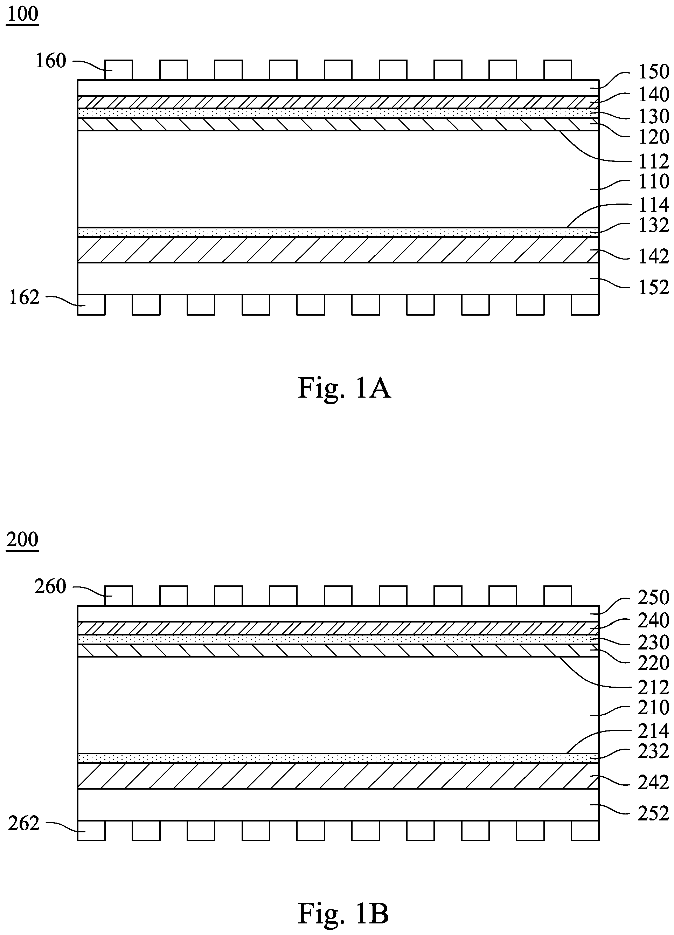

Fig. 1A illustrates a schematic cross-sectional view of a solar cell in accordance with some embodiments. A solar cell 100 includes an N-type silicon substrate 110 having a first side 112 and a second side 114 opposite to the first side 112. In some embodiments, the solar cell 100 is a single-sided solar cell in which the first side 112 is a light-receiving surface, and the second side 114 is a non-light-receiving surface. In other embodiments, the solar cell 100 is a double-sided solar cell, and both of the first side 112 and the second side 114 may be light-receiving surfaces. The structural layers over the first side 112 of the N-type silicon substrate 110 are in the order of an emitter layer 120, a first thin oxide layer 130, a first doped silicon layer 140, a first capping layer 150, and a first electrode layer 160. The structural layers over the second side 114 of the N-type silicon substrate 110 are in the order a second thin oxide layer 132, a second doped silicon layer 142, a second capping layer, and a second electrode layer 162.

A PN junction is formed between the N-type silicon substrate 110 and the emitter layer 120. The emitter layer 120 is a silicon layer doped with a first conductivity type of dopant, for example, a group III element, such as boron. The first doped silicon layer 140 also includes a first conductivity type of dopant, such as boron. The second doped silicon layer 142 includes a second conductivity type of dopant different from the first conductivity type of dopant, for example, group V elements, such as phosphorus.

The first thin oxide layer 130 is sandwiched by the emitter layer 120 and the first doped silicon layer 140. The second thin oxide layer 132 is sandwiched by the N-type silicon substrate 110 and the second doped silicon layer 142. The first thin oxide layer 130 and the second thin oxide layer 132 are oxide layers simultaneously formed in one process stage. The material of the first and the second thin oxide layers may be, for example, silicon oxide or aluminum oxide.

A first doped silicon layer 140 is formed on the first thin oxide layer 130, and a second doped silicon layer 142 is formed on the second thin oxide layer 132. The silicon deposition in the formation process of the first doped silicon layer 140 and the second doped silicon layer 142 is a silicon deposition process simultaneously performed on both sides of the N-type silicon substrate 110. In some embodiments, the first doped silicon layer 140 and the second doped silicon layer 142 are polycrystalline. In other embodiments, the first doped silicon layer 140 and the second doped silicon layer 142 may be monocrystalline or amorphous.

The first capping layer 150 is disposed on the first doped silicon layer 140, and the second capping layer 152 is disposed on the second doped silicon layer 142. The first capping layer 150 and the second capping layer 152 may include silicon nitride or silicon oxide; or the first capping layer 150 and the second capping layer 152 may be a multi-layer structure of silicon nitride or silicon oxide. For example, the first capping layer 150 and the second capping layer 152 may include a passivation layer formed of silicon nitride and an anti-reflection layer formed of silicon oxide.

A first electrode layer 160 is disposed on the first capping layer 150, and a second electrode layer 162 is disposed on the second capping layer 152. The first electrode layer 160 and the second electrode layer 162 may be a metal electrode, a transparent electrode, or stacked layers thereof. For example, the metal electrode may be a silver electrode, an aluminum electrode, a nickel electrode, a copper electrode, an alloy electrode, or a metal composite electrode. Further, in some embodiments, the electrodes in the first electrode layer 160 and the second electrode layer 162 may be strip-shaped. In other embodiments, one of the first electrode layer 160 and the second electrode layer 162 may be a covering electrode, for example, the first electrode layer 160 entirely covers the first capping layer 150, or the second electrode layer 162 entirely covers the second capping layer 152.

Fig. 1B illustrates a schematic cross-sectional view of a solar cell in accordance with other embodiments. The solar cell 200 is similar to the solar cell shown in Fig. 1A, and the main difference is that the solar cell 200 is a P-type solar cell.

In the solar cell 200, a P-type silicon substrate 210 has a first side 212 and a second side 214 opposite to the first side 212. The structural layers over the first side 212 of the P-type silicon substrate 210 are in the order of an emitter layer 220, a first thin oxide layer 230, a first doped silicon layer 240, a first capping layer 250, and a first electrode layer 260. The structural layers over the second side 214 of the P-type silicon substrate 210 are in the order of a second thin oxide layer 232, a second doped silicon layer 242, a second capping layer 252, and a second electrode layer 262.

A PN junction is formed between the P-type silicon substrate 210 and the emitter layer 220. The emitter layer 220 is a silicon layer doped with a first conductivity type of dopant, for example, a group V element, such as phosphorus. The first doped silicon layer 240 also includes a first conductivity type of dopant, such as phosphorus. The second doped silicon layer 242 includes a second conductivity type of dopant different from the first conductivity type of dopant, for example, a group III element, such as boron.

The structures of the solar cell provided by the embodiments of the present disclosure can be applied to N-type solar cells (as shown in Fig. 1A) or P-type solar cells (as shown in Fig. 1B).

The structures or the manufacturing methods of the solar cell provided by the embodiments of the present disclosure may be applied to, but not limited to, tunnel oxide passive contact (TOPCon) solar cells, passivated emitter rear locally-diffused (PERL) solar cells, passivated emitter rear totally-diffused (PERT) solar cells, interdigitated back contact (IBC) solar cells, hetero-junction with Intrinsic thin layer (HIT) solar cells, hetero-junction back contact (HBC) solar cells, or the like.

Tunnel oxide passivated contact (TOPCon) solar cells are high-performance solar cells developed from hetero-junction cell structures in recent years. An N-type silicon substrate is employed in a TopCon solar cell, and the back side of the silicon substrate is covered with a very thin layer of silicon oxide; next, the very thin layer of silicon oxide is covered with a layer of doped polycrystalline silicon or doped amorphous silicon. When the solar cell is in operation, electrons from the N-type silicon substrate tunnel through the silicon oxide layer into the doped polycrystalline/amorphous silicon layer. The silicon oxide layer (tunnel oxide layer) having a thickness of 1∼2 nm has good selectivity to allow electrons to pass through the silicon layer while the recombination of the electron holes to be blocked. The thin oxide layer can provide excellent passivation effect for the N-type silicon substrate, reduce the recombination rate of the carriers on the surface of the silicon substrate, and improve the performance of the solar cell.

In some embodiments of the present disclosure, the solar cell is a TOPCon solar cell, in which the second thin oxide layer 132 shown in Fig. 1A is a tunnel oxide layer. When the solar cell is operating, the electrons from the N-type silicon substrate 110 tunnels through the second thin oxide layer 132 into the second doped silicon layer 142.

In a conventional method for manufacturing a solar cell, when a deposition process (e.g., silicon deposition) is performed on one surface (e.g., non-light-receiving surface) of the substrate, winding coating often occurs on the other surface or the edge of the substrate. The following clean process for removing the winding coating may cause damage or defects on the surface(s) or the edge of the substrate; hence, the yield is reduced. Therefore, how to improve the solar cell manufacturing process to remove the problems caused by winding coating is an important issue in this field.

In addition, in the conventional method for manufacturing a TOPCon solar cell, a rough surface (e.g., a surface with pyramid structures) is generally formed on the surface of the front side of the substrate to reduce the reflection of light, and then an emitter layer with boron diffusion is formed at the front side of the substrate. Next, atomic layer deposition (ALD) is performed on the emitter layer to deposit alumina on the emitter layer to achieve surface passivation, and then the emitter layer is covered with a layer of silicon nitride (Si₃N₄) and/or a layer of silicon oxide (SiO₂). Then, silicon deposition is performed on the back side of the substrate.

However, during the process of performing ALD to deposit aluminum oxide, trimethyl aluminum (TMA), an expensive gas, is used in the current process, which makes it difficult to reduce the cost for manufacturing solar cells.

In addition, during the current process, when the silicon layer is deposited on the back surface of the substrate, silicon winding coating often occurs on the front side or the edge of the substrate. The silicon winding coating often causes damage in the pyramid structures on the front side and surface defects of the substrate; hence, the yield is reduced.

In the method for manufacturing a solar cell provided by the present disclosure, the first thin oxide layer and the second thin oxide layer are formed by a double-sided deposition process, and the silicon layers of the first doped silicon layer and the second doped silicon layer are also formed by a double-sided deposition process. Therefore, the winding coating in single-side deposition process and the problems caused by the winding coating are reduced.

Referring to Fig. 1A again, in some embodiments of the present disclosure, the solar cell further includes a first doped silicon layer 140 disposed over the emitter layer 120 and the first thin oxide layer 130, and the first doped silicon layer 140 includes the same conductivity type of dopant as the emitter layer 120. In the first doped silicon layer 140, the dopant diffuses from the emitter layer 120 into the silicon layer via a thermal diffusion process. Therefore, the dopant has the highest concentration on the side closest to the first thin oxide layer 130, and the concentration of the dopant gradually decreases toward the first capping layer 150. The first doped silicon layer 140 can reduce the recombination of minority carriers; for example, in some embodiments, the implied open circuit voltage (implied VOC, or iVOC) of the solar cell is increased by 8% to 10%; therefore, the first doped silicon layer 140 can provide passivation function.

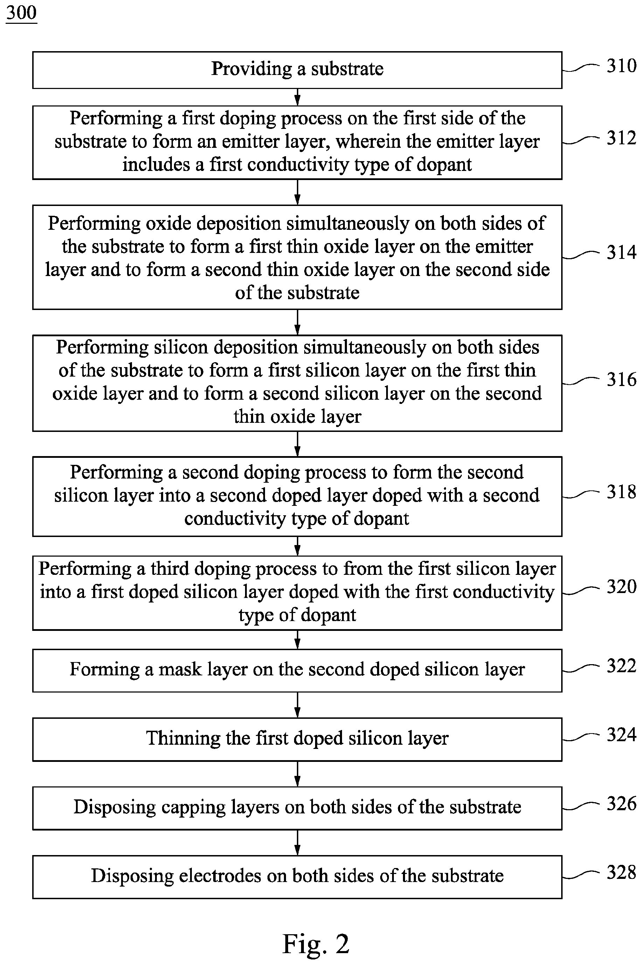

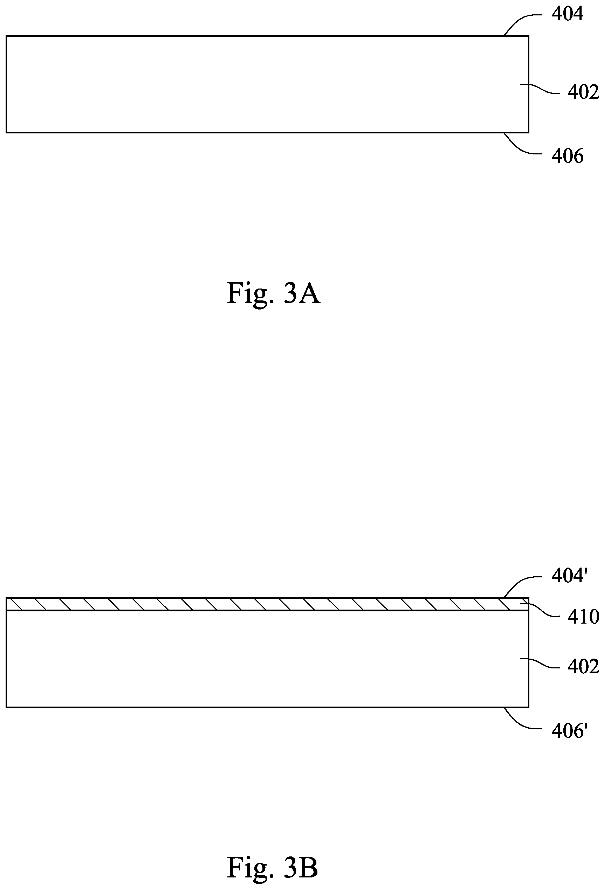

Please refer to Fig. 2 and Figs. 3A through 3J. Fig. 2 illustrates a flow chart for manufacturing a solar cell according to some embodiments, and Figs. 3A through 3J illustrate the cross-sectional views of the solar cell at various stages of the manufacturing process. For ease of explanation, Figs. 3A through 3J are mainly described via an example of an N-type solar cell; however, the disclosure is not limited thereto.

It is noted that although the operations shown in Fig. 2 and the cross-sectional views shown in Figs. 3A through 3J are described by reference to a method, it is understood that the structures shown in Figs. 3A to 3J are not limited to this method but may be separated from this method. Although Fig. 2 and Figs. 3A through 3J are described as a series of acts, it is understood that the acts are not limited to the order of the acts, the order of the acts may be changed in other embodiments, and the disclosed methods can also be applied to other structures. In other embodiments, some of the acts shown and/or described may be omitted in whole or in part.

Referring to Fig. 2, in step 310 of method 300, a substrate is provided; referring to Fig. 3A, which illustrates a substrate 402 having a first side 404 and a second side 406 opposite to the first side 404. In some embodiments, the substrate 402 may be made of polycrystalline silicon or monocrystalline silicon, and the substrate may be an N-type silicon substrate or a P-type silicon su bstrate.

Optionally, the surface of the first side of the substrate is etched by, for example, wet etching, so that pyramid structures are formed on the surface of the substrate, or the surface of the substrate is formed into a textured surface; therefore, the receiving light will not be easily reflected out, and the light absorption of the solar cell is enhanced. Other non-smooth arrangements that facilitate light absorption are also within the scope of the present disclosure.

In step 312 of method 300, a first doping process is performed to form an emitter layer on the first side of the substrate, wherein the emitter layer includes a first dopant. Referring to Fig. 3B, after the first doping process, an emitter layer 410 is formed adjacent to the first side 404' of the substrate 402.

When the silicon substrate is an N-type silicon substrate, the emitter layer is a P-type silicon layer, for example, a boron-doped silicon layer. When the silicon substrate is a P-type silicon substrate, the emitter layer is an N-type silicon layer, for example, a phosphorus-doped silicon layer.

In some embodiments, a thermal diffusion process may be used in the boron diffusion process on the first side 404 of the substrate 402; during the process in a high-temperature furnace, boron bromide (BBR₃) is used as the boron diffusion source for performing boron diffusion. Alternatively, boron diffusion may be performed by depositing borosilicate glass (BSG) on the surface of the substrate using atmospheric pressure chemical vapor deposition (APCVD).

In some embodiments, BSG is produced on the second side (back side) and/or the first side (front side) of the substrate during the doping process. Accordingly, a removal process is then performed; for example, an etchant including hydrofluoric acid is used to remove the BSG on the back side and/or the front side of the substrate 402 to expose the first side 404' and a second side 406' of the substrate 402.

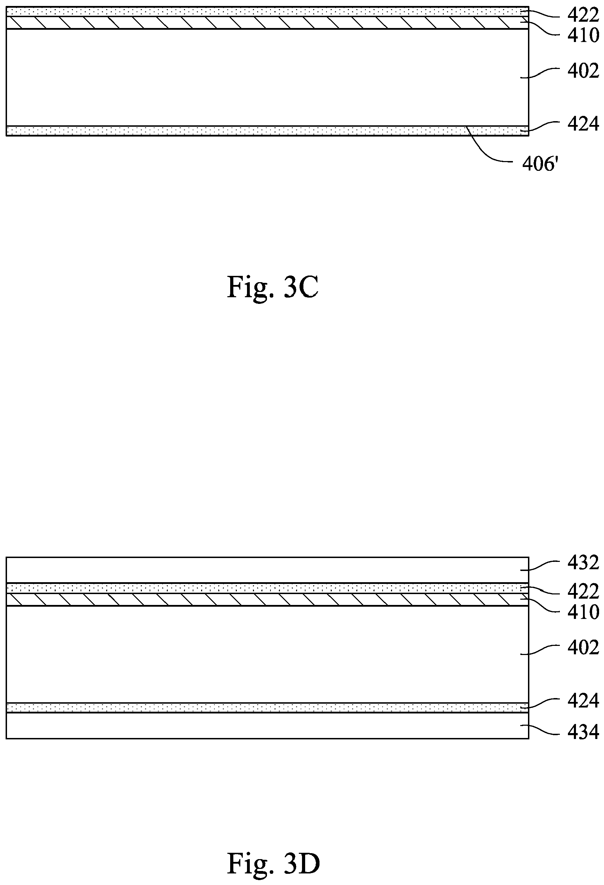

In step 314 of method 300, oxide deposition is performed simultaneously on both sides of the substrate. Referring to Figs. 3B and 3C, a first thin oxide layer 422 is formed on the emitter layer 410, and a second thin oxide layer 424 is formed on the second side 406' of the substrate 402.

The material of the first thin oxide layer 422 and the second thin oxide layer 424 may be silicon oxide or aluminum oxide, and the thickness of the first thin oxide layer 422 and the second thin oxide layer 424 may be in a range between 0.5 nm to 16 nm, preferably between 1 to 4 nm, and more preferably between 1 to 2 nm. The oxide deposition on both sides of the substrate may be performed by using LPCVD or plasma enhanced chemical vapor deposition (PECVD).

In step 316 of method 300, silicon deposition is performed simultaneously on both sides of the substrate. Referring to Fig. 3D, a first silicon layer 432 is formed on the first thin oxide layer 422, and a second silicon layer 434 is formed on the second thin oxide layer 424.

The silicon deposition on both sides of the substrate may be performed by using LPCVD or PECVD.

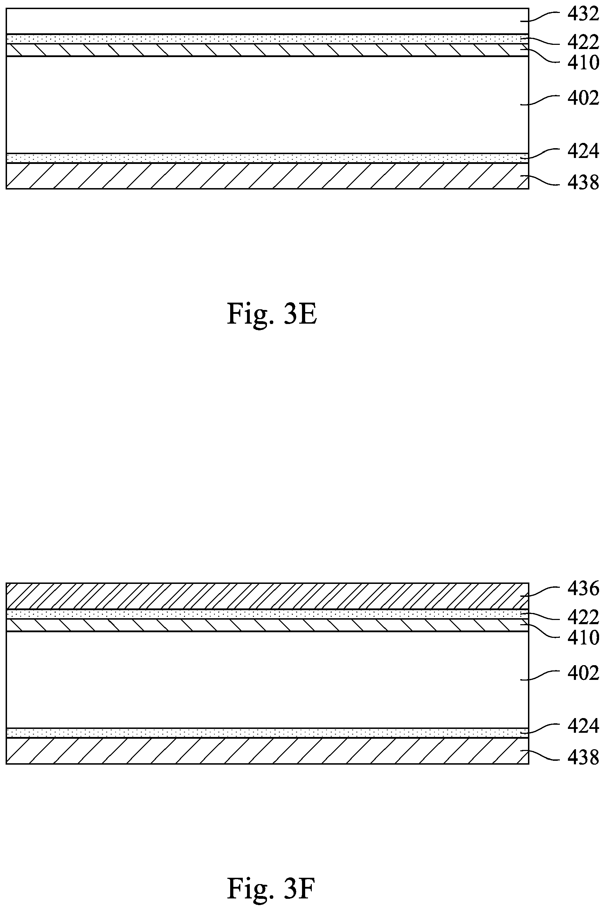

In step 318 of method 300, a second doping process is performed to implant a second dopant into the second silicon layer, so that the silicon layer is formed into a second doped silicon layer containing the second dopant. Referring to Fig. 3E, after the second doping process is performed, the second silicon layer 434 is formed into a second doped silicon layer 438. In some embodiments, the second doping process includes an annealing process, and the second doped silicon layer 438 forms a doped polysilicon layer.

The second dopant and the first dopant are different conductivity types of dopants, for example, while the first dopant is boron, the second dopant is phosphorus. A thermal diffusion process may be used to perform phosphorus diffusion, for example, POCl₃ is used as the phosphorus diffusion source in a high-temperature furnace. Alternatively, phosphorus is implanted into the second silicon layer 434 by ion implantation.

In step 320 of method 300, a third doping process is performed to diffuse the first dopant from the emitter layer to the first silicon layer to form the first doped silicon layer. Referring to Fig. 3F, after the third doping process is performed, the first silicon layer is formed into a first doped silicon layer 436. In some embodiments, the third doping process includes an annealing process, and the first doped silicon layer 436 is formed into a doped polysilicon layer.

Because the first dopant diffuses from the emitter layer 410, in the first doped silicon layer 436, the concentration of the first dopant is highest at the side near the first thin oxide layer 422.

The third doping process is performed by a thermal diffusion process. In some embodiments, the third doping process is performed after the second doping process. In other embodiments, the third doping process may be performed simultaneously with the second doping process. For example, when the second doping process is performed in a high-temperature furnace in a thermal diffusion process, boron ions in the emitter layer diffuse outward into the first silicon layer 432.

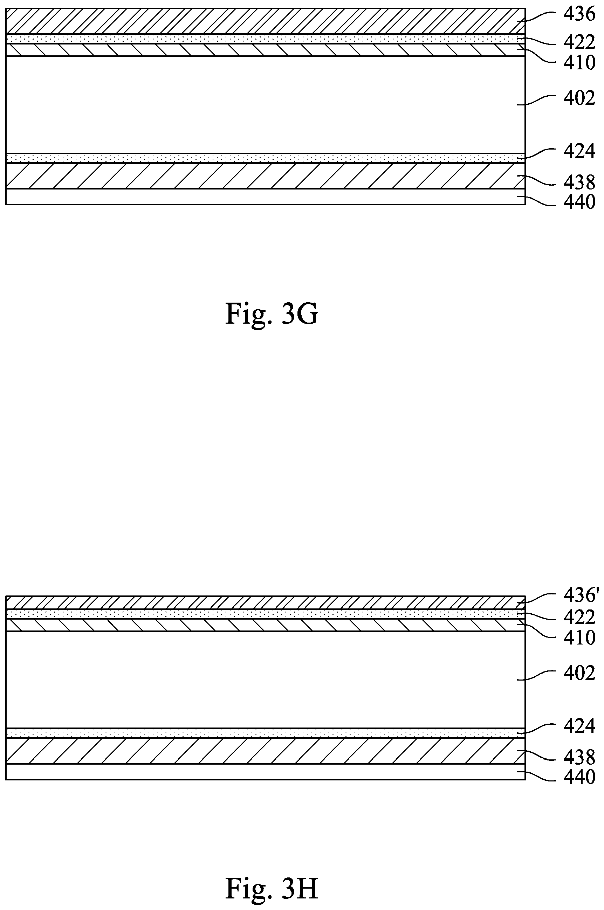

In step 322 of method 300, a mask layer is formed on the second doped silicon layer. Referring to Fig. 3G, a mask layer 440 is formed on the second doped silicon layer 438.

The material of the mask layer 440 is a material that is not etched by a subsequent etching process, for example, the mask layer 440 is a layer of silicon nitride (Si₃N₄) or silicon oxide (SiO₂), or the mask layer 440 is a multi-layer structure containing both a silicon nitride (Si₃N₄) layer and a silicon oxide (SiO₂) layer. The mask layer 440 can be used to protect the underlying second doped silicon layer 438 from being etched in the etching process. Depositing silicon nitride or silicon oxide on the second doped silicon layer 438 may be performed by using PECVD.

In step 324 of method 300, the first doped silicon layer is thinned. Fig. 3H illustrates the thinned first doped silicon layer 436'. If the silicon layer is too thick, the reflection of light will be reduced; therefore, a thinning process is performed to reduce the thickness of the first doped silicon layer 436 for reducing the light loss.

In some embodiments, before thinning the first doped silicon layer, the phosphosilicate glass (PSG) deposited on the first silicon layer 432 during the second doping process is removed.

In some embodiments, the thickness of the thinned first doped silicon layer 436' may be in a range from 20 to 200 nm, preferably 25 to 150 nm, and more preferably 30 to 100 nm.

In some embodiments, the first doped silicon layer 436 is thinned by wet etching, for example, wet etching using sodium hydroxide (KOH) as an etchant.

In some embodiments, since the silicon nitride (Si₃N₄) layer or silicon oxide (SiO₂) layer has passivation and anti-reflection effects in the solar cell, it is not necessary to remove the mask layer 440 after the etching process is completed.

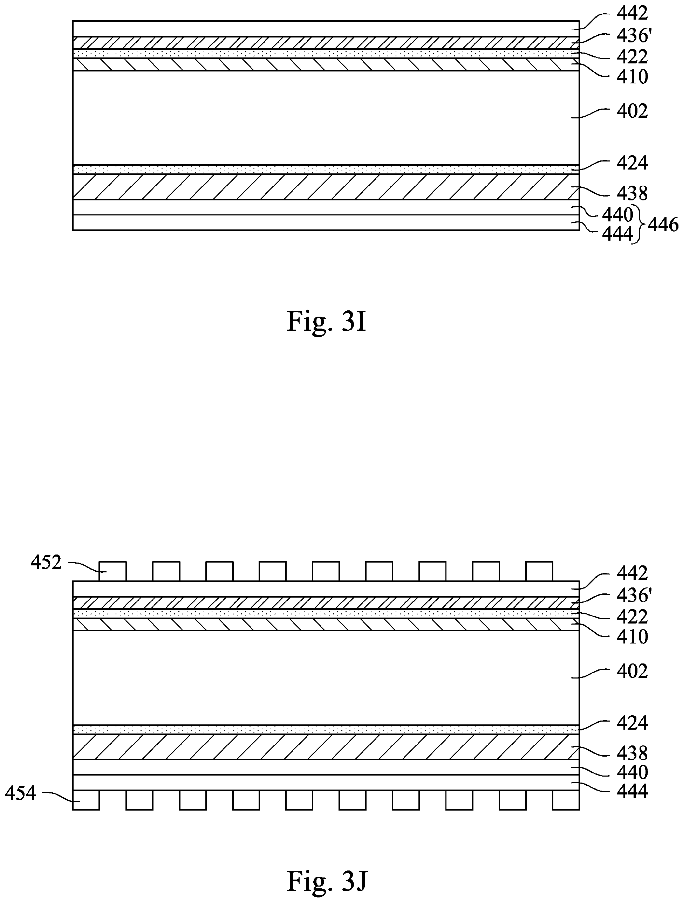

In step 326 of method 300, capping layers are disposed on both sides of the substrate. Referring to Fig. 3I, a first capping layer 442 is deposited on the first doped silicon layer 436', and a second capping layer 444 is disposed on the mask layer 440. In some embodiments, the first capping layer 442 and the second capping layer 444 are disposed simultaneously. In other embodiments, the first capping layer 442 and the second capping layer 444 are disposed separately.

The first capping layer 442 and the second capping layer 444 respectively are a layer of silicon nitride (Si₃N₄) or a layer of silicon oxide (SiO₂), or a multi-layer structure comprising both a silicon nitride layer and a silicon oxide layer. Depositing the silicon nitride layers and/or the silicon oxide layers simultaneously on both sides of the substrate 402 may be performed by using PECVD.

In some embodiments, the mask layer 440 and the second capping layer 444 are a composite capping layer 446 having passivation and anti-reflection effects.

In step 328 of method 300, electrodes are disposed on both sides of the substrate. Referring to Fig. 3J, a first electrode layer 452 is disposed on the first capping layer 442, and a second electrode layer 454 is disposed on the second capping layer 444.

In some embodiments, screen printing may be used to coat silver paste or aluminum paste on the first capping layer 442 and the second capping layer 444, followed by sintering to form electrodes.

The process for manufacturing a solar cell provided by the embodiments of the present disclosure adopts the simultaneous formation of thin oxide layers and silicon layers on both sides of the substrate, thereby reducing the problems of winding coating that often occurs during one-sided deposition. Therefore, it is not necessary to clean the winding coating on one of the surfaces of the substrates, so that the yield of solar cell is enhanced, the manufacturing processes are simplified, and the cost of manufacturing the solar cell is reduced.

In the solar cell provided by the embodiments of the present disclosure, the doped silicon layer formed on the other side of the substrate further provides the function of a passivation layer, and the thin oxide layer sandwiched by the emitter layer and the doped silicon layer also provides partial passivation function. Therefore, the manner that disposing a thin oxide layer and a thinned doped silicon layer over the emitter layer of the solar cell provides passivation function for the surface of the emitter layer (e.g., the surface of a silicon layer with boron diffusion); therefore, the recombination rate of the minority carriers can be reduced. Also, since the structural layers (e.g., the thin oxide layers and the silicon layers) on both sides of the substrate are simultaneously disposed during manufacturing, the process steps are simplified. In addition, since an aluminum oxide layer is not used as the passivation layer of the solar cell, the manufacturing processes are reduced, and expensive TMA gas is not used. Further, the efficiency of the photovoltaic conversion of the solar cell is enhanced, because the thinned doped silicon layer can effectively passivate the surface of the emitter layer, and the light reflectance caused by the doped silicon layer is controlled to a relatively low state.

Although particular embodiments have been described herein, it will be appreciated that the invention is not limited thereto and that many modifications and additions thereto may be made within the scope of the invention. For example, various combinations of the features of the following dependent claims can be made with the features of the independent claims without departing from the scope of the present invention.

## Claims

1. A solar cell (100) comprising:
a substrate (110) having a first side (112) and a second side (114) opposite to each other;
an emitter layer (120) disposed on the first side (112) of the substrate (110), wherein the emitter layer (120) comprises a first conductivity type of dopant;
a first thin oxide layer (130) disposed on the emitter layer (120);
a first doped silicon layer (140) disposed on the first thin oxide layer (130), wherein the first doped silicon layer (140) comprises the first conductivity type of dopant;
a second thin oxide layer (132) disposed on the second side (114) of the substrate (110); and
a second doped silicon layer (142) disposed on the second thin oxide layer (132), wherein the second doped silicon layer (142) comprises a second conductivity type of dopant.

2. The solar cell (100) of claim 1, wherein the first doped silicon layer (140) has a thickness smaller than a thickness of the second doped silicon layer (142).

3. The solar cell (100) of claim 1 or claim 2, wherein a concentration of the first conductivity type of dopant in the first doped silicon layer (140) is highest at a side adjacent to the first thin oxide layer (130).

4. The solar cell (100) of any one of claims 1 to 3, wherein the first doped silicon layer (140) configured to provide passivation function.

5. The solar cell (100) of any one of claims 1 to 4, further comprising a mask layer (440) disposed on the second doped silicon layer (438), wherein the mask layer (440) comprises: silicon nitride, silicon oxide, or a combination thereof.

6. The solar cell (100) of any one of claims 1 to 5, wherein the solar cell (100) is a tunnel oxide passive contact (TOPCon) solar cell.

7. The solar cell (100) of any one of claims 1 to 6, wherein the substrate (110) is an N-type silicon substrate, the first conductivity type of dopant is a group III element, and the second conductivity type of dopant is a group V element.

8. The solar cell (100) of any one of claims 1 to 7, wherein the first conductivity type of dopant is boron, and the second conductivity type of dopant is phosphorus.

9. The solar cell (200) of any one of claims 1 to 5, wherein the substrate (210) is a P-type substrate, the first conductivity type of dopant is a group V element, and the second conductivity type of dopant is a group III element.

10. A method for manufacturing a solar cell (100), comprising:
providing a substrate (402), wherein the substrate (402) comprises a first side (404) and a second side (406) opposite to each other;
performing a first doping process on the first side (404) of the substrate (402) to form an emitter layer (410) doped with a first conductivity type of dopant;
performing oxide deposition to form a first thin oxide layer (422) on the emitter layer (410) and to form a second thin oxide layer (424) on the second side (406) of the substrate (402);
performing silicon deposition to form a first silicon layer (432) on the first thin oxide layer (422) and to form a second silicon layer (434) on the second thin oxide layer (424);
performing a second doping process to form the second silicon layer (434) into a second doped silicon layer (438) doped with a second conductivity type of dopant; and
performing a third doping process to form the first silicon layer (432) into a first doped silicon layer (436) doped with the first conductivity type of dopant.

11. The method for manufacturing the solar cell (100) of claim 10, wherein the third doping process is a thermal diffusion process, and the first conductivity type of dopant diffuses from the emitter layer (410) into the first silicon layer (432).

12. The method for manufacturing the solar cell (100) of claim 10 or claim 11, wherein the third doping process is performed during the performing of the second doping process.

13. The method for manufacturing the solar cell of any one of claims 10 to 12, further comprising:
depositing a mask layer (440) on the second doped silicon layer (438); and
performing a thinning process for the first doped silicon layer (436).

14. The method for manufacturing the solar cell (100) of claim 13, wherein a material of the mask layer (440) comprises: silicon nitride, silicon oxide, or a combination thereof.
